# EUROPÄISCHE PATENTSCHRIFT

(11) **EP 0 986 942 B1**
(45) Veröffentlichungstag und Bekanntmachung des Hinweises auf die Patenterteilung: **02.01.2002**
(21) Anmeldenummer: 98936103.5
(22) Anmeldetag: 04.06.1998
(51) Int. Cl.: H05K 13/02, H05K 13/04

(54) **VORRICHTUNG ZUM BEREITSTELLEN VON ELEKTRISCHEN BAUELEMENTEN AN EINEM BESTÜCKAUTOMATEN**
DEVICE FOR CHARGING ELECTRICAL COMPONENTS IN AN AUTOMATIC PLACEMENT MACHINE
DISPOSITIF POUR CHARGER DES COMPOSANTS ELECTRIQUES DANS UNE MACHINE AUTOMATIQUE A IMPLANTER LES COMPOSANTS

(30) Priorität: 04.06.1997 DE 19723452
(43) Veröffentlichungstag der Anmeldung: 22.03.2000
(73) Patentinhaber: SIEMENS AKTIENGESELLSCHAFT, 80333 München (DE)
(72) Erfinder: MEHDIANPOUR, Mohammad, D-81829 München (DE); SCHOLL, Bernd-Friedrich, D-70771 Echterdingen (DE)
(86) Internationale Anmeldenummer: DE9801537
(87) Internationale Veröffentlichungsnummer: WO9856228

(56) Entgegenhaltungen:
- DE-A- 2 934 999
- DE-A- 3 040 357
- GB-A- 2 061 894
- GB-A- 2 147 888

## Beschreibung

Vorrichtung zum Bereitstellen von elektrischen Bauelementen an einem Bestückautomaten

Die Erfindung bezieht sich auf eine Vorrichtung zum Bereitstellen von elektrischen Bauelementen, insbesondere SMD-Bauelementen im Abholbereich eines in einer Arbeitsebene verfahrbaren Greifers eines Bestückautomaten.

Es ist z.B. durch die EP-A-0 116 922 bekannt, die Bauelemente in Stangenmagazinen zusammenzufassen; die über der Arbeitsebene flach liegend und parallel zueinander angeordnet sind. Es ist üblich, die Bauelemente in den Stangenmagazinen derart anzuordnen, daß sie mit ihren schmalen Stirnseiten aneinanderstoßen. Das heißt, daß ihre Längsrichtung mit der Längsrichtung des Stangenmagazins übereinstimmt. Die Bauelemente werden mit Hilfe von Vibrationslängsförderern vorgeschoben, wobei das jeweils vorderste Bauelement in einer Führungsbahn gegen einen Anschlag rutscht, der einen Abholplatz definiert, aus dem das Bauelement mittels des Greifers nach oben herausgehoben werden kann.

Ferner ist es durch das IBM Technical Disclosure Bulletin Vol. 31, No.5, Oct. 1988, New York US, S. 129-130 bekannt, Bauteile in der Konfiguration bereit zu stellen, in der sie auf der zu bestückenden Leiterplatte angeordnet werden sollen. Die Bauteile werden dann mittels einer Vakuumplatte angesaugt und in einem Arbeitsgang gemeinsam auf die Leiterplatte aufgesetzt. Die Bauteile sind in senkrecht zur Arbeitsebene stehenden Röhren bereitgestellt, in denen sie flach übereinander liegend gestapelt sind. Auf der Unterseite der Bauelemente sind in den Röhren Kolben im Schiebe-Klemmsitz angeordnet, die ein Absinken der Bauteile verhindern. Während des Aufsetzens der Vakuumplatte sind die Kolben mit Druckluft beaufschlagbar, so daß die Bauelemente gegen die Vakuumplatte gedrückt werden.

Ferner ist durch die GB-A-2 147 888 eine Vorrichtung zum Bereitstellen von Bauelementen bekannt, die querliegend in einem senkrechten Stapelmagazin unterhalb der Arbeitsebene angeordnet sind. Das Stapelmagazin weist eine gesteuerte Hubeinrichtung auf, durch die die Bauelemente schrittweise zu einer oberen Austrittsöffnung angehoben werden können, wo sie von einem Greifer der Bestückeinrichtung entnehmbar sind. Durch die steuerbare Hubeinrichtung ist es möglich, die Bauelemente entsprechend ihrer Entnahme durch den Greifer nachzuschieben.

Durch die GB-A-2 061 894 ist außerdem ein senkrecht stehendes Stangenmagazin mit einer sich verengenden oberen Austrittsöffnung bekannt, durch die querliegenden Bauelemente spielarm gegen eine Saugplatte gedrückt werden können. Ein Sperrelement auf der Unterseite des Magazins verhindert das Zurückrutschen der Bauelemente.

Der Erfindung liegt die Aufgabe zugrunde, die Bauteilezuführung für eine wahlfreie Einzelentnahme zu vereinfachen und die Anzahl der bereitgestellten Bauteile zu erhöhen.

Diese Aufgabe wird durch die Erfindungen gemäß den Ansprüchen 1 oder 6 gelöst. Vorteilhafte Weiterbildungen der Erfindung sind in den anderen Ansprüchen gekennzeichnet.

Durch die Erfindung nach Anspruch 1 können nun Stangenmagazine verwendet werden, bei denen die Bauelemente in der gleichen Weise angeordnet sind, wie dies bei den bekannten flachliegenden Stangenmagazinen üblich ist. Die Bauelemente können in ähnlicher Weise wie die querliegenden gehandhabt werden. Die Kippeinrichtung kann passiv ausgebildet und durch eine besondere Formgebung im Bereich des oberen Magazinendes realisiert sein. Die Stangenmagazine können in zweidimensionaler Verteilung im Abholbereich des Greifers in entsprechend großer Anzahl angeordnet werden.

Durch eine Weiterbildung nach Anspruch 2 kann das Bauelement mit einfachen Gestaltungsmitteln raumsparend in die Abholposition gebracht werden.

Die Begrenzung der Hubbewegung nach Anspruch 3 ermöglicht eine einfache Steuerung des Hubmechanismus ohne genaue Dosierung und Überwachung der Hublänge.

Der Sensor nach Anspruch 4 stellt ein mechanisch passives Mittel dar und kann ein einfacher Weise mit einem z.B. elektrisch betätigten Antriebsorgan gekoppelt werden.

Durch den Anschlag nach Anspruch 5 wird eine gleichmäßige und genaue Abholhöhe der Bauelemente eingehalten. Die Kippeinrichtung kann unmittelbar über dem Anschlag angeordnet sein.

Durch die Erfindung nach Anspruch 6 ist es möglich, eine große Anzahl von Bauelementen im Stangenmagazin zu speichern. Durch den Anschlag wird eine gleichmäßige und genaue Abholhöhe der Bauelemente eingehalten. Die Hubeinrichtung ist so gesteuert, daß sich der Anschlag in seiner Funktionstellung befindet, während das Antriebsorgang eingeschaltet ist. Wurde zuvor aus dem Stangenmagazin ein Bauelement entnommen, so wird der Vorrat bis zum Anschlag vorgeschoben. Danach wird das Antriebsorgan abgeschaltet, wobei das Sperrorgan ein Zurücksinken der Bauelemente verhindert. Danach wird der Anschlag aus seiner Funktionsstellung entfernt, so daß das oberste Bauelement frei zugänglich ist und ohne jede weitere Hilfsvorrichtung unmittelbar vom Greifer erfaßt werden kann. Ein besonderer Vorteil besteht darin, daß auf diese Weise mehrere Magazine gleichzeitig angesteuert werden können, wobei die Bauelemente jeweils nur in dem Magazin nachgeschoben werden, aus dem zuvor ein Bauelement entnommen wurde.

Der Schieber nach Anspruch 7 stellt ein einfaches und einfach zu betätigendes Konstruktionselement dar.

Die unmittelbare Halterung und Führung des Schiebers am Stangenmagazin nach Anspruch 8 läßt sich mit geringem Herstellungsaufwand raumsparend verwirklichen. Ein. besonderer Vorteil besteht darin, daß der Schieber zusammen mit dem Stangenmagazin geliefert werden kann und daß der Schieber außerdem als Transportverschluß für das Stangenmagazin dienen kann.

Durch die Weiterbildung nach Anspruch 9 wird für eine Vielzahl von Stangenmagazinen nur ein Schieber mit einem einzigen Betätigungsmechanismus benötigt.

Die Anordnung nach Anspruch 10 ermöglicht die Bereitstellung einer Vielzahl von Bauelementen und insbesondere einer Vielzahl von Bauelementtypen auf engem Raum.

Durch die Vorrichtung nach Anspruch 11 wird die Hubeinrichtung und die Energiezufuhr zu dieser erheblich vereinfacht. Ein besonderer Vorteil besteht darin, daß der Arbeitsdruck des fluidischen Mediums in einer einzigen Vorrichtung erzeugt werden kann, die alle Stangenmagazine versorgt. Bei einer Druckluftbetätigung der Kolben können die Stangenmagazine einer Vielzahl von Bestückautomaten an eine zentrale Druckluftversorgung angeschlossen sein.

Das Sperrorgan nach den Ansprüchen 12 und 13 kann mit geringem Herstellungsaufwand als einfaches Spritzgußteil ausgebildet sein.

Durch die Weiterbildung nach den Ansprüchen 14 und 15 wird ein kostengünstiges integriertes Bauteil gebildet. Der Abstand zwischen den beiden Kolben ist so groß, daß zwischen ihnen das Sperrorgan Platz findet. Die Führungslänge dieses Bauteils wird dadurch so groß, daß ein Verkanten und Verklemmen im Stangenmagazin nicht möglich ist. Durch die Anordnung des Sperrorgans zwischen den beiden Kolben wird eine genaue Lagezuordnung der Spreizelemente zum Stangenmagazin erreicht.

Im folgenden wird die Erfindung anhand von in der Zeichnung dargestellten Ausführungsbeispielen näher erläutert.
- Figur 1: zeigt einen seitlichen Schnitt durch eine Reihe von Stangenmagazinen mit einem Schieber und einer Druckluftzufuhr,
- Figur 2: eine Draufsicht auf die Stangenmagazine nach Figur 1,
- Figur 3: einen vergrößerten Schnitt durch das Stangenmagazin nach Figur 1 mit geöffnetem Schieber,
- Figur 4: das Stangenmagazin nach Figur 3 mit geschlossenem Schieber,
- Figur 5: einen Schnitt durch ein anderes Stangenmagazin mit einer Kippeinrichtung und einem Stößel.

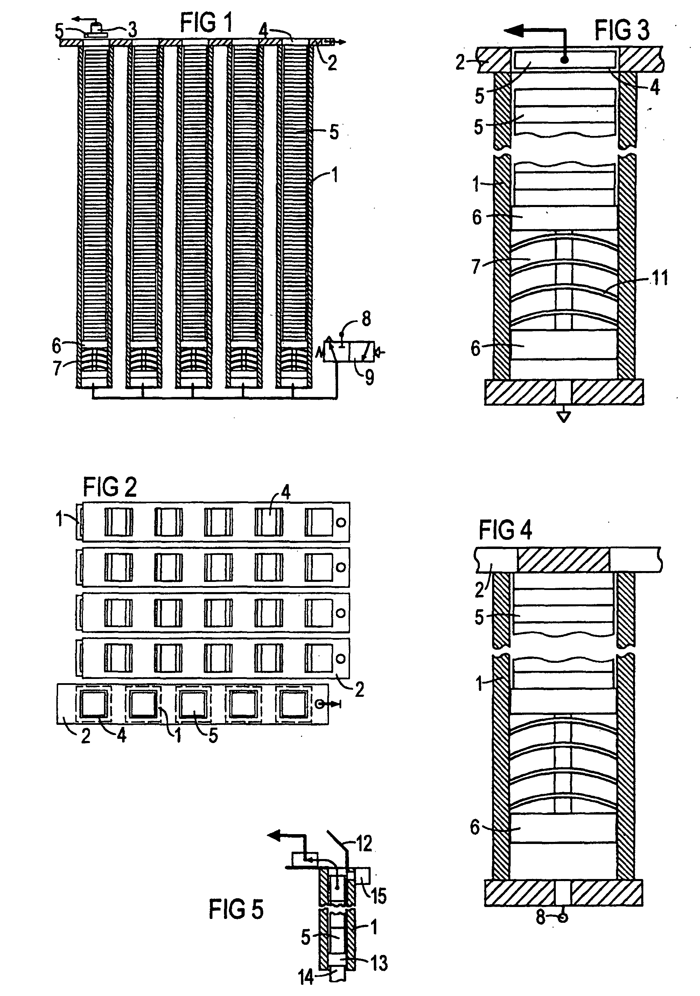

Nach den Figuren 1 und 2 sind'mehrere längliche Stangenmagazine 1 zueinander parallel stehend in mehreren Spalten und Reihen matrixartig angeordnet. An den oberen Enden der Stangenmagazine 1 ist für jeweils eine Reihe ein Schieber 2 angeordnet, der sich senkrecht zur Längsrichtung der Stangenmagazine 1 erstreckt und in dieser Richtung verschiebbar ist. Die in einer Ebene angeordneten Schieber 2 erstrecken sich parallel zu einer Arbeitsebene eines Greifers 3 eines Bestückautomaten.

Der Schieber 2 weist Freimachungen 4 auf, zum Durchlaß vom im Stangenmagazin 1 gestapelten elektrischen Bauelementen 5 auf. Der Schieber 2 ist zwischen 2 Stellungen verschiebbar, in denen die oberen Enden der Stangenmagazine 1 entweder geöffnet oder geschlossen sind. In der geöffneten Stellung ist der z. B. aus Saugpipette ausgebildete Greifer 3 durch die Freimachung 4 hindurch auf das jeweils oberste der Bauelemente 5 absenkbar. Nach dem Ansaugen des Bauelementes 4 wird dieses über das Niveau der Schieber 2 angehoben und gemäß der Pfeilrichtung z. B. zu einer zu bestückenden Leiterplatte transportiert, die an einem Bestückplatz des Bestückautomaten plaziert ist.

Die Stangenmagazine 1 erstrecken sich von der Arbeitsebene aus senkrecht nach unten. Die Bauelemente 5 sind in den Stangenmagazinen 1 querliegend gestapelt, so daß ihre vom Greifer zu erfassende Oberseite der Arbeitsebene zugewandt ist. Unterhalb des Bauelementevorrats ist in dem Stangenmagazin 1 'ein Antriebsorgan in Form eines Kolbens eingesetzt, der mit einem Sperrorgan 7 verbunden ist. Das Sperrorgan 7 ist so ausgebildet, daß es freilaufartig mit geringer Kraft in die Richtung des Schiebers 2 bewegt werden kann und daß eine Rückbewegung durch ein spreizendes Verklemmen im Stangenmagazin verhindert wird.

Das untere Ende jeweils einer Reihe der Stangenmagazine 1 ist an eine Druckluftquelle 8 mittels eines Ventils 9 schaltbar angeschlossen, wobei das Ventil 9 auf Entlüftung geschaltet ist, so daß die Kolben 6 lediglich mittels eines Sperrorgans 7 in ihrer Höhenlage gehalten werden. Dabei sind die oberen Bauelemente 5 durch den geöffneten Schieber hindurch ungehindert entnehmbar.

Diese Schaltstellung ist in Figur 2 in der untersten Reihe der Stangenmagazine 1 gezeigt. In den darüberliegenden Reihen sind die Schieber 2 entsprechend der angegebenen Pfeilrichtung soweit nach rechts verschoben, daß sich die Freimachungen 4 zwischen den Stangenmagazinen 1 befinden und das die zwischen den Freimachungen 4 befindlichen Abschnitte die oberen Enden der Stangenmagazine 1 überdecken. Diese Abschnitte bilden somit bewegliche Anschläge für die Bauelemente 5, so daß in dieser Stellung das Ventil 9 auf die Druckluftquelle 8 umgeschaltet werden kann. Die Kolben 6 werden dann durch die Druckluft nach oben gedrückt, bis die obersten Bauelemente 5 am Schieber 2 anschlagen.

Figur 3 zeigt das entlüftete Stangenmagazin 1 während der Entnahme eines der Bauelemente 5 gemäß der Pfeilrichtung. Der Kolben 6 ist in das Hohlprofil des Stangenmagazins 1 spielfrei gleitend eingepaßt, so daß im Falle der Druckbeaufschlagung kaum Leckverluste entstehen. Er ist mit einem zweiten beabstandenden Kolben über einen dünnen Steg 10 einstückig verbunden.

An dem Steg 10 sind ferner querstehende lamellenartige Sperrelemente 11 angebracht, die sich zwischen diametral gegenüberliegenden Seitenwänden des Stangenmagazins 1 bogenförmig verspannen, wobei die konvexe Seite der Sperrelemente 11 in die Vorschubrichtung weist. Beim Vorschieben des Kolbens 6 sind die Sperrelemente 11 derart nachgiebig, daß sie der Vorschubbewegung nur einen geringen Widerstand entgegensetzen. Nach dem Abschalten der Druckluftzufuhr wird der Kolben 6 durch das Eigengewicht der Bauelemente 5 in der umgekehrten Richtung belastet, wobei die Enden der flachgekrümmten Sperrelemente 11 mit hoher Kraft gegen die Seitenwände des Stangenmagazins 1 gedrückt werden und so ein Zurücksinken des Kolbens 6 verhindern.

Figur 4 zeigt die Antriebsstellung des Stangenmagazins 1 unter Druckbeaufschlagung. Dabei ist die Unterseite des Kolbens 6 mit Druckluft beaufschlagt, so daß dieser die Bauelemente 5 bis zum Anschlag am Schieber 2 nach oben drückt.

Figur 5 zeigt ein anderes Stangenmagazin 1, in dem die Bauelemente 5 derart aneinander gereiht sind, daß sich ihre zu greifenden Oberseiten parallel zur Längsrichtung der Stangenmagazine 1 erstrecken. Am oberen Ende des Stangenmagazins 1 befindet sich eine Kippeinrichtung 12, die das jeweils heraus zu schiebende Bauelement 5 in eine abholbereite Schwenklage dreht, wobei sich der Abholplatz neben dem oberen Ende des Stangenmagazins 1 befindet.

Anstelle des Kolbens ist hier ein Stößel 13 vorgesehen, der durch einen teleskopartig verfahrbaren Antrieb 14 in der Art einer motorisch ausfahrbaren Fahrzeugantenne in der Längsrichtung des Stangenmagazins 1 schrittweise verschiebbar ist. Am oberen Ende des Stangenmagazins 1 befindet sich ein als Lichtschranke ausgebildeter Sensor 15 durch den die Vorschubbewegung des Antriebs 14 abschaltbar ist.

## Patentansprüche

1. Vorrichtung zum Bereitstellen von elektrischen Bauelementen (5), insbesondere SMD-Bauelementen im Abholbereich eines in einer Arbeitsebene verfahrbaren Greifers (3) eines Bestückautomaten,
wobei in einem Bestückbereich des Bestückautomaten ein Bauelementeträger platzierbar ist, auf den die Bauelemente (5) aufsetzbar sind,
wobei die Bauelemente (5) in zumindest einem Stangenmagazin (1) aufgenommen sind, aus dem sie zu einem im Arbeitsbereich gelegenen Abholplatz transportierbar sind, wo sie einzeln und wahlfrei vom Greifer (3) aufnehmbar sind,
wobei das Stangenmagazin (1) in seiner Längsrichtung zumindest annähernd senkrecht zur Arbeitsebene und im wesentlichen unterhalb von dieser angeordnet ist,
wobei dem Stangenmagazin (1) eine gesteuert antreibbare Hubeinrichtung zum wahlfreien und schrittweisen Nachschieben der Bauelemente (5) zugeordnet ist und
wobei ein Antriebsorgan (z.B. 6) der Hubeinrichtung auf der der Arbeitsebene abgewandten Unterseite des Bauelementevorrates angeordnet ist,
**dadurch gekennzeichnet,**
**daß** sich die später dem Bauelementeträger abgewandten Oberseiten der gestapelten Bauelemente (5) in der Längsrichtung des Stangenmagazines (1) erstrecken,
**daß** die Bauelemente (5) durch die Hubeinrichtung aus dem Stangenmagazin (1) herausschiebbar sind und
**daß** die Bauelemente (5) beim Verlassen des Stangenmagazines (1) mittels einer Kippeinrichtung (12) in eine Lage drehbar sind, in der sich die Oberseite parallel zur Arbeitsebene erstreckt.

2. Vorrichtung nach Anspruch 1,
**dadurch gekennzeichnet,**
**daß** der Abholplatz unmittelbar neben dem Stangenmagazin (1) angeordnet ist.

3. Vorrichtung nach Anspruch 1 oder 2,
**dadurch gekennzeichnet,**
**daß** die Hubeinrichtung im Bereich des oberen Endes des Stangenmagazins (1) Mittel (15) zur Begrenzung der Hubbewegung der Bauelemente (5) aufweist und
**daß** das Antriebsorgan (6) der Hubeinrichtung mit dem Erreichen der entsprechenden Hubhöhe abschaltbar ist.

4. Vorrichtung nach Anspruch 3,
**dadurch gekennzeichnet,**
**daß** die Mittel zur Hubbegrenzung als Sensor (15) zur Erkennung der Hubhöhe des obersten Bauelements (5) des Stangenmagazins (1) ausgebildet sind und
**daß** der Sensor (15) das Abschalten der Hubbewegung auslöst.

5. Vorrichtung nach Anspruch 3,
**dadurch gekennzeichnet,**
**daß** die Mittel zur Hubbegrenzung als beweglicher Anschlag ausgebildet sind,
**daß** die Hubeinrichtung mit einer die Rückbewegung des Antriebsorgans (z.B. 6) verhindernden Sperreinrichtung (z.B. 7) versehen ist und
**daß** der Anschlag nach dem Abschalten des Antriebs aus der Bewegungsbahn der Bauelemente (5) entfernbar ist.

6. Vorrichtung zum Bereitstellen von elektrischen Bauelementen (5), insbesondere SMD-Bauelementen im Abholbereich eines in einer Arbeitsebene verfahrbaren Greifers (3) eines Bestückautomaten,
wobei die Bauelemente (5) in zumindest einem Stangenmagazin (1) aufgenommen sind, aus dem sie zu einem im Arbeitsbereich gelegenen Abholplatz transportierbar sind, wo sie einzeln und wahlfrei vom Greifer (3) aufnehmbar sind,
wobei das Stangenmagazin (1) in seiner Längsrichtung zumindest annähernd senkrecht zur Arbeitsebene und im wesentlichen unterhalb von dieser angeordnet ist,
wobei dem Stangenmagazin (1) eine gesteuert antreibbare Hubeinrichtung zum wahlfreien und schrittweisen Nachschieben der Bauelemente (5) zugeordnet ist,
wobei ein Antriebsorgan (z.B. 6) der Hubeinrichtung auf der der Arbeitsebene abgewandten Unterseite des Bauelementevorrates angeordnet ist,
wobei sich die Oberseiten der Bauelemente (5) im Stangenmagazin (1) quer zu dessen Längsrichtung erstrecken und
wobei eine der Arbeitsebene zugeordnete stirnseitige Entnahmeöffnung des Stangenmagazines (1) den Abholplatz bildet,
**dadurch gekennzeichnet,**
**daß** die Hubeinrichtung im Bereich der Entnahmeöffnung des Stangenmagazins (1) einen beweglichen Anschlag zur Begrenzung der Hubbewegung der Bauelemente (5) aufweist,
**daß** das Antriebsorgan (z.B. 6) der Hubeinrichtung nach Erreichen des Anschlags abschaltbar ist,
**daß** die Hubeinrichtung mit einer die Rückbewegung des Antriebsorgans (z.B. 6) verhindernden Sperreinrichtung (z.B. 7) versehen ist und
**daß** der Anschlag nach dem Abschalten des Antriebs aus der Bewegungsbahn der Bauelemente (5) entfernbar ist.

7. Vorrichtung nach Anspruch 5 oder 6 ,
**dadurch gekennzeichnet,**
**daß** der Anschlag an einem quer zum Stangenmagazin (1) verschiebbaren Schieber (2) ausgebildet ist.

8. Vorrichtung nach Anspruch 7,
**dadurch gekennzeichnet,**
**daß** der Schieber (2) und das Stangenmagazin (1) sich wechselseitig hintergreifende Führungsformen aufweisen, die eine unmittelbare Halterung und Führung des Schiebers (2) am Stangenmagazin (1) ermöglichen.

9. Vorrichtung nach Anspruch 7 oder 8,
**dadurch gekennzeichnet,**
**daß** für mehrere einander benachbarte Stangenmagazine (1) ein gemeinsamer Schieber (2) vorgesehen ist, der mit Freimachungen (4) zum Durchlaß der Bauelemente (5) versehen ist.

10. Vorrichtung nach Anspruch 9,
**dadurch gekennzeichnet,**
**daß** mehrere zueinander parallel stehende Stangenmagazine (1) in zwei Koordinatenrichtungen verteilt angeordnet sind und
**daß** der Schieber (2) für jeweils eine Reihe der Stangenmagazine (1) vorgesehen ist.

11. Vorrichtung nach einem der vorhergehenden Ansprüche,
**dadurch gekennzeichnet,**
**daß** das Antriebsorgan als fluidisch betätigbarer Kolben (6) mit einem, dem Hohlprofil des Stangenmagazins (1) angepaßten Querschnitt ausgebildet ist,
**daß** der Kolben (6) auf der der Entnahmeöffnung abgewandten Unterseite des Bauelementevorrates in das Stangenmagazin (1) verschiebbar eingesetzt ist und
**daß** die Sperreinrichtung als dem Kolben (6) zugeordnetes Sperrorgan (7) ausgebildet ist, das zumindest ein freilaufähnlich wirkendes Sperrelement (11) aufweist, das an der Innenwand des Stangenmagazines (1) angreift.

12. Vorrichtung nach Anspruch 11,
**dadurch gekennzeichnet,**
**daß** das Sperrelement (11) als federnd nachgiebiges, sich quer zur Stangenrichtung erstreckendes Spreizelement ausgebildet ist, das schrägstehend an der Innenwand des Stangenmagazines (1) angreift.

13. Vorrichtung nach Anspruch 12,
**dadurch gekennzeichnet,**
**daß** das Sperrelement (11) als lamellenartige Biegefeder ausgebildet ist, die zur Entnahmeöffnung hin konvex gebogen ist und die zwischen einander diametral gegenüberliegenden Seitenwänden des Stangenmagazines (1) verspannt ist.

14. Vorrichtung nach Anspruch 13,
**dadurch gekennzeichnet,**
**daß** das Spreizelement an einem Steg (10) befestigt ist, der sich im Mittelabschnitt des Spreizelementes in der Längsrichtung des Stangenmagazines (1) erstreckt und mit dem Kolben einstückig verbunden ist.

15. Vorrichtung nach Anspruch 14,
**dadurch gekennzeichnet,**
**daß** das Sperrorgan (7) zwischen zwei hintereinander angeordneten Kolben (6) der Hubeinrichtung angeordnet ist.

## Claims

1. Apparatus for providing electrical components (5), in particular SMD components in the collection region of a gripper (3) of an automatic placement machine, which gripper can be moved in an operating plane,
wherein a component carrier onto which the components (5) can be placed can be positioned in a placement region of the automatic placement machine,
wherein the components (5) are accommodated in at least one bar magazine (1) from which they can be transported to a collection location located in the operating region, where they can be picked up individually and randomly by the gripper (3),
wherein the bar magazine (1) is arranged, in its longitudinal direction, at least approximately perpendicularly to the operating plane and essentially below the latter,
wherein the bar magazine (1) is assigned a lifting device which can be driven in a controlled manner and serves for randomly and progressively advancing the components (5), and
wherein a drive member (e.g. 6) of the lifting device is arranged on the underside of the component store, which underside is remote from the operating plane,
**characterized**
**in that** the top sides of the stacked components (5), which top sides are subsequently remote from the component carrier, extend in the longitudinal direction of the bar magazine (1),
**in that** the components (5) can be pushed out from the bar magazine (1) by the lifting device, and
**in that** the components (5), when leaving the bar magazine (1), can be rotated by means of a tilting device (12) into a position in which the top side extends parallel to the operating plane.

2. Apparatus according to Claim 1,
**characterized**
**in that** the collection location is arranged directly beside the bar magazine (1).

3. Apparatus according to Claim 1 or 2,
**characterized**
**in that** the lifting device has, in the region of the upper end of the bar magazine (1), means (15) for limiting the lifting movement of the components (5), and in that the drive member (6) of the lifting device can be switched off when the corresponding lifting height is reached.

4. Apparatus according to Claim 3,
**characterized**
**in that** the lifting limiting means are designed as a sensor (15) for identifying the lifting height of the topmost component (5) of the bar magazine (1), and
**in that** the sensor (15) triggers the switching-off of the lifting movement.

5. Apparatus according to Claim 3,
**characterized**
**in that** the lifting limiting means are designed as a movable stop,
**in that** the lifting device is provided with a blocking device (e.g. 7) which prevents the reverse movement of the drive member (e.g. 6), and
**in that**, after the drive has been switched off, the stop can be removed from the movement path of the components (5).

6. Apparatus for providing electrical components (5), in particular SMD components in the collection region of a gripper (3) of an automatic placement machine, which gripper can be moved in an operating plane,
wherein the components (5) are accommodated in at least one bar magazine (1) from which they can be transported to a collection location located in the operating region, where they can be picked up individually and randomly by the gripper (3),
wherein the bar magazine (1) is arranged, in its longitudinal direction, at least approximately perpendicularly to the operating plane and essentially below the latter,
wherein the bar magazine (1) is assigned a lifting device which can be driven in a controlled manner and serves for randomly and progressively advancing the components (5), and
wherein a drive member (e.g. 6) of the lifting device is arranged on the underside of the component store, which underside is remote from the operating plane,
wherein the top sides of the components (5) in the bar magazine (1) extend transversely with respect to the longitudinal direction thereof, and
wherein an end removal opening of the bar magazine (1), which opening is assigned to the operating plane, forms the collection location,
**characterized**
**in that** the lifting device has, in the region of the removal opening of the bar magazine (1), a movable stop for limiting the lifting movement of the components (5),
**in that** the drive member (e.g. 6) of the lifting device can be switched off after the stop is reached,
**in that** the lifting device is provided with a blocking device (e.g. 7) which prevents the reverse movement of the drive member (e.g. 6), and
**in that**, after the drive has been switched off, the stop can be removed from the movement path of the components (5).

7. Apparatus according to Claim 5 or 6,
**characterized**
**in that** the stop is formed on a slide (2) which can be displaced transversely with respect to the bar magazine (1) .

8. Apparatus according to Claim 7,
**characterized**
**in that** the slide (2) and the bar magazine (1) have guide forms which reciprocally engage behind one another and enable direct retention and guidance of the slide (2) on the bar magazine (1).

9. Apparatus according to Claim 7 or 8,
**characterized**
**in that**, for a plurality of mutually adjacent bar magazines (1), a common slide (2) is provided which is provided with apertures (4) for passage of the components (5).

10. Apparatus according to Claim 9,
**characterized**
**in that** a plurality of mutually parallel bar magazines (1) are arranged in a manner distributed in two coordinate directions, and
**in that** the slide (2) is provided for a respective row of the bar magazines (1).

11. Apparatus according to one of the preceding claims,
**characterized**
**in that** the drive member is designed as a fluidically actuable piston (6) with a cross section which is adapted to the hollow profile of the bar magazine (1),
**in that** the piston (6) is inserted displaceably into the bar magazine (1) on the underside of the component store, which underside is remote from the removal opening, and
**in that** the blocking device is designed as a blocking member (7) which is assigned to the piston (6) and has at least one blocking element (11) which acts in a freewheel-like manner and engages on the inner wall of the bar magazine.

12. Apparatus according to Claim 11,
**characterized**
**in that** the blocking element (11) is designed as a resiliently compliant spreading element which extends transversely with respect to the bar direction and engages obliquely on the inner wall of the bar magazine (1).

13. Apparatus according to Claim 12,
**characterized**
**in that** the blocking element (11) is designed as a lamella bending spring which is bent convexly towards the removal opening and is braced between mutually diametrically opposite side walls of the bar magazine (1).

14. Apparatus according to Claim 13,
**characterized**
**in that** the spreading element is fixed to a web (10) which extends in the central section of the spreading element in the longitudinal direction of the bar magazine (1) and is integrally connected to the piston.

15. Apparatus according to Claim 14,
**characterized**
**in that** the blocking member (7) is arranged between two pistons (6) of the lifting device which are arranged one behind the other.

## Revendications

1. Dispositif pour fournir des composants (5) électriques, notamment des composants CMS (composants montés en surface), dans la région d'enlèvement d'un preneur (3), pouvant être déplacé dans un plan de travail, d'une machine automatique d'emplacement,
un support de composants, sur lequel les composants (5) peuvent être posés, pouvant être placé dans une zone d'emplacement de la machine automatique d'implantation,
les composants (5) étant reçus dans au moins un magasin (1) à barres, d'où ils peuvent être transportés vers un emplacement d'enlèvement situé dans la zone de travail, où ils peuvent être pris en charge individuellement et à volonté par le preneur (3),
le magasin (1) à barres étant disposé en ayant sa direction longitudinale au moins à peu près perpendiculaire au plan de travail et en étant sensiblement en dessous de celui-ci,
un dispositif de levage à entraînement commandé étant associé au magasin (1) à barres pour faire avancer pas à pas et à volonté les composants (5),
et un organe (6 par exemple) d'entraînement du dispositif de levage étant disposé sur la face inférieure, éloignée du plan de travail, de la réserve de composants,
**caractérisé en ce que** les faces supérieures, ultérieurement éloignées du support de composants, des composants (5) empilés s'étendent dans la direction longitudinale du magasin (1) à barres,
**en ce que** les composants (5) peuvent être poussés hors du magasin (1) à barres par le dispositif de levage,
et **en ce que** les composants (5), lorsqu'ils quittent le magasin (1) à barres, peuvent être tournés au moyen d'un dispositif (12) de basculement dans une position dans laquelle leur face supérieure s'étend parallèlement au plan de travail.

2. Dispositif suivant la revendication 1,
**caractérisé**
**en ce que** l'emplacement d'enlèvement est disposé juste à côté du magasin (1) à barres.

3. Dispositif suivant la revendication 1 ou 2,
**caractérisé**
**en ce que** le dispositif de levage comporte, dans la région de l'extrémité supérieure du magasin (1) à barres, des moyens (15) pour limiter la course de déplacement des composants (5), et
**en ce que** l'organe (6) d'entraînement du dispositif de levage peut être désactivé à l'atteinte du niveau de course adéquat.

4. Dispositif suivant la revendication 3,
**caractérisé**
**en ce que** les moyens pour limiter la course sont réalisés sous la forme d'un capteur (15) pour détecter le niveau de course du composant (5) supérieur du magasin (1) à barres, et
**en ce que** le capteur (15) déclenche la désactivation du mouvement de course.

5. Dispositif suivant la revendication 3,
**caractérisé**
**en ce que** les moyens pour limiter la course sont réalisés sous la forme d'une butée mobile,
**en ce que** le dispositif de levage est doté d'un dispositif (7 par exemple) de blocage empêchant le recul de l'organe (6 par exemple) d'entraînement, et
**en ce que** la butée peut, une fois l'entraînement désactivé, être écartée de la voie de déplacement des composants (5).

6. Dispositif pour fournir des composants (5) électriques, notamment des composants CMS (composants montés en surface), dans la région d'enlèvement d'un preneur (3), pouvant être déplacé dans un plan de travail, d'une machine automatique d'implantation,
les composants (5) étant reçus dans au moins un magasin (1) à barres, d'où ils peuvent être transportés vers un emplacement d'enlèvement situé dans la zone de travail, où ils peuvent être pris en charge individuellement et à volonté par le preneur (3),
le magasin (1) à barres étant disposé, dans sa direction longitudinale, au moins à peu près perpendiculaire au plan de travail et sensiblement en dessous de celui-ci,
un dispositif de levage à entraînement commandé étant associé au magasin (1) à barres pour faire avancer pas à pas et à volonté les composants (5),
un organe (6 par exemple) d'entraînement du dispositif de levage étant disposé sur la face inférieure, éloignée du plan de travail, de la réserve de composants,
les faces supérieures des composants (5) dans le magasin (1) à barres s'étendant transversalement à la direction longitudinale de celui-ci,
et une ouverture frontale de prélèvement du magasin (1) à barres, associée au plan de travail, constituant l'emplacement d'enlèvement,
**caractérisé**
**en ce que** le dispositif de levage comporte dans la région de l'ouverture de prélèvement du magasin (1) à barres une butée mobile pour limiter la course de déplacement des composants (5),
**en ce que** l'organe (6 par exemple) d'entraînement du dispositif de levage peut être désactivé à l'atteinte de la butée,
**en ce que** le dispositif de levage est doté d'un dispositif (7 par exemple) de blocage empêchant le recul de l'organe (6 par exemple) d'entraînement,
et **en ce que** la butée peut, une fois l'entraînement désactivé, être écartée de la voie de déplacement des composants (5).

7. Dispositif suivant la revendication 5 ou 6,
**caractérisé**
**en ce que** la butée est formée sur un coulisseau (2) pouvant être déplacé transversalement au magasin (1) à barres.

8. Dispositif suivant la revendication 7,
**caractérisé**
**en ce que** le coulisseau (2) et le magasin (1) à barres comportent des conformations de guidage s'accrochant mutuellement, qui permettent de maintenir et de guider directement le coulisseau (2) sur le magasin (1) à barres.

9. Dispositif suivant la revendication 7 ou 8,
**caractérisé**
**en ce qu'**il est prévu un coulisseau (2) commun à plusieurs magasins (1) à barres voisins, qui est doté d'ouvertures (4) pour le passage des composants (5).

10. Dispositif suivant la revendication 9,
**caractérisé**
**en ce que** plusieurs magasins (1) à barres mutuellement parallèles sont disposés en étant répartis dans deux directions de coordonnées, et en ce que le coulisseau (2) est prévu pour chaque rangée respective de magasins (1) à barres.

11. Dispositif suivant l'une des revendications précédentes,
**caractérisé**
**en ce que** l'organe d'entraînement est réalisé sous forme de piston (6) actionné par fluide et dont la section est adaptée au profil creux du magasin (1) à barres,
**en ce que** le piston (6) est inséré à coulissement dans le magasin (1) à barres sur la face inférieure, éloignée de l'ouverture de prélèvement, de la réserve de composants, et
**en ce que** le dispositif de blocage est réalisé sous forme d'organe (7) de blocage associé au piston (6), organe qui comporte au moins un élément (11) de blocage agissant à la manière d'un mécanisme à roue libre, qui agit contre la paroi intérieure du magasin (1) à barres.

12. Dispositif suivant la revendication 11,
**caractérisé**
**en ce que** l'élément (11) de blocage est réalisé sous forme d'un élément d'écartement cédant élastiquement, s'étendant transversalement à la direction des barres et qui agit en oblique sur la paroi intérieure du magasin (1) à barres.

13. Dispositif suivant la revendication 12,
**caractérisé**
**en ce que** l'élément (11) de blocage est réalisé sous la forme d'un ressort de flexion du genre lamelle, qui est à courbure convexe en direction de l'ouverture de prélèvement et qui est tendu entre des parois latérales diamétralement opposées du magasin (1) à barres.

14. Dispositif suivant la revendication 13,
**caractérisé**
**en ce que** l'élément d'écartement est fixé sur une entretoise (10), qui s'étend dans la partie médiane de l'élément d'écartement dans la direction longitudinale du magasin (1) à barres et qui est reliée d'un seul tenant au piston.

15. Dispositif suivant la revendication 14,
**caractérisé**
**en ce que** l'organe (7) de blocage est disposé entre deux pistons (6) successifs du dispositif de levage.
